# EUROPEAN PATENT APPLICATION

(11) **EP 4 190 836 A1**
(43) Date of publication of application: **07.06.2023**
(21) Application number: 21852159.9
(22) Date of filing: 27.07.2021
(51) Int. Cl.: C08G 61/06, H01L 23/29, H01L 23/31, C08L 65/00

(54) **CYCLOOLEFIN RESIN CURED PRODUCT**

(30) Priority: 03.08.2020 JP 2020131973
(71) Applicant: RIMTEC Corporation, Tokyo 100-0005 (JP)
(72) Inventor: KAMEI, Nobuhito, Tokyo 100-0005 (JP); SHOCHIKU, Shingo, Tokyo 100-0005 (JP)
(74) Representative: Beckmann, Claus
(86) International application number: PCT/JP2021/027763
(87) International publication number: WO 2022/030310

(57) **Abstract**

Provided is a cycloolefin resin cured product formed through bulk polymerization of a polymerizable composition comprising a cycloolefin monomer and a metathesis polymerization catalyst, wherein the cycloolefin monomer includes a norbornene-based monomer (a1) and a monocyclic cycloolefin (a2), and the cycloolefin resin cured product has an elongation at break at 23°C of 30% or more.

## Description

### TECHNICAL FIELD

The present invention relates to a cycloolefin resin cured product, and more specifically relates to a cycloolefin resin cured product having high crack resistance, high stretching properties, and excellent high-temperature durability.

### BACKGROUND ART

Cycloolefin resins are known for their high mechanical strength, high heat resistance, low moisture absorbing properties, high dielectric properties, and the like, and have been used in a variety of applications.

For example, Patent Document 1 describes examinations of such a cycloolefin resin when used in sealing of semiconductor elements. In the technique disclosed in Patent Document 1, the cycloolefin resin is used in sealing of semiconductor elements utilizing properties of the cycloolefin resin due to low viscosity of its monomer solution, which lead to large freedom in forming and short-time applicability and curability.

On the other hand, it is verified that cracks and breakage occur in molded articles having a complicated structure and composite molded articles with a filler or a metal member under environments at low or high temperature or even under an environment at normal temperature due to concentration of internal stress. There is a demand for a resin material having high durability at normal temperature, excellent temperature-cycle reliability under environments at low and high temperatures, and high durability in long-term use in preparation of a highly functional composite material with another material and complex forming utilizing its low viscosity.

### RELATED ART DOCUMENTS

### Patent Document

Patent Document 1: JP 2013-48295 A

### SUMMARY OF THE INVENTION

### PROBLEM TO BE SOLVED BY THE INVENTION

The present inventors have examined use of cycloolefin resins as resin materials while utilizing the properties of cycloolefin resins due to low viscosities of their monomer solutions, which lead to large freedom in forming and short-time applicability and curability, and have found that cured products prepared from these cycloolefin resins were cracked during formation or under usage environments and had poor reliability and durability. These problems were remarkably observed in the case where the cycloolefin resins contained a filler.

The present invention has been made in consideration of such circumstances, and an object of the present invention is to provide a cycloolefin resin cured product having high crack resistance, high stretching properties, and excellent high-temperature durability, and a polymerizable composition suitably used in formation of the cured product.

### MEANS FOR SOLVING PROBLEMS

The present inventors, who have conducted extensive research to achieve the above object, have found that the above object can be achieved by using a norbornene-based monomer (a1) and a monocyclic cycloolefin (a2) as cycloolefin monomers for forming a cycloolefin resin cured product and controlling the elongation at break of the cycloolefin resin cured product at normal temperature to 30% or more. Thus, the present inventors have completed the present invention.

Specifically, the present invention provides a cycloolefin resin cured product formed through bulk polymerization of a polymerizable composition comprising a cycloolefin monomer and a metathesis polymerization catalyst,
wherein the cycloolefin monomer includes a norbornene-based monomer (a1) and a monocyclic cycloolefin (a2), and
the cycloolefin resin cured product has an elongation at break at 23°C of 30% or more.

In the cycloolefin resin cured product according to the present invention, the content of the monocyclic cycloolefin (a2) in the cycloolefin monomer is preferably 30 to 99% by mass.

In the cycloolefin resin cured product according to the present invention, the monocyclic cycloolefin (a2) is preferably 1,5-cyclooctadiene, cyclooctene, cyclohexene, 1,4-cyclohexadiene, or 1,4-p-menthadiene.

In the cycloolefin resin cured product according to the present invention, the polymerizable composition preferably contains a filler.

The present invention also provides a polymerizable composition for forming the cycloolefin resin cured product, the polymerizable composition comprising a cycloolefin monomer and a metathesis polymerization catalyst,
wherein the cycloolefin monomer includes a norbornene-based monomer (a1) and a monocyclic cycloolefin (a2).

The polymerizable composition according to the present invention is preferably in the form of two or more preparative liquid formulations each of which alone is not capable of polymerization, and can be formed by combining the preparative liquid formulations.

### EFFECTS OF INVENTION

The present invention can provide a cycloolefin resin cured product having high crack resistance, high stretching properties, and excellent high-temperature durability.

### DESCRIPTION OF EMBODIMENTS

The cycloolefin resin cured product according to the present invention is a cycloolefin resin cured product formed through bulk polymerization of a polymerizable composition comprising a cycloolefin monomer and a metathesis polymerization catalyst, wherein the cycloolefin monomer includes a norbornene-based monomer (a1) and a monocyclic cycloolefin (a2), and the cycloolefin resin cured product has an elongation at break at 23°C of 30% or more.

### <Polymerizable composition>

First, the polymerizable composition used for production of the cycloolefin resin cured product according to the present invention will be described.

The polymerizable composition used for production of the cycloolefin resin cured product according to the present invention comprises a cycloolefin monomer and a metathesis polymerization catalyst.

The cycloolefin monomer is a compound having a ring structure formed by carbon atoms, the ring having a carbon-carbon double bond.

In the present invention, at least a norbornene-based monomer (a1) and a monocyclic cycloolefin (a2) are used as the cycloolefin monomers.

The norbornene-based monomer (a1) can be any compound having a norbornene ring structure, and is not particularly limited. Examples thereof include bicyclic compounds such as norbornene, norbornadiene, and vinylnorbornene; tricyclic compounds such as dicyclopentadiene and dihydrodicyclopentadiene; tetracyclic compounds such as tetracyclododecene and ethylidene tetracyclododecene; pentacyclic compounds such as tricyclopentadiene; heptacyclic compounds such as tetracyclopentadiene; derivatives thereof having an alkenyl group, an alkynyl group, an alkylidene group, an epoxy group, or an (meth)acrylic substitute (such as an ethylidene substitute); and the like. These norbornene-based monomers (a1) can be used alone or in combination. As the norbornene-based monomer (a1), preferred are tricyclic compounds, and particularly preferred is dicyclopentadiene because they can further enhance the effects of the present invention. A combination of a tricyclic compound with a pentacyclic compound is also suitable to further enhance the effects of the present invention. A preferred pentacyclic compound is tricyclopentadiene. For the proportions of these compounds when a tricyclic compound is used in combination with a pentacyclic compound, the mass ratio of the tricyclic compound to the pentacyclic compound in the norbornene-based monomer (a1) is preferably 50:50 to 98:2, more preferably 65:35 to 95:5, still more preferably 80:20 to 93:7.

To improve adhesion of the resulting cured product to substrates (e.g., semiconductor elements when the cycloolefin resin cured product is used as a sealing material for semiconductor elements), preferred derivatives are those having an epoxy group. Examples thereof include 4,5-epoxytricyclo[5.2.1.0^{2,6}]deca-8-ene [also referred to as dicyclopentadiene monoepoxide (2,3-DCPME); in this specification, it is simply referred to as DCPME in some cases], 4,5-epoxy-8-chlorotricyclo[5.2.1.0^{2,6}]deca-8-ene, 4,5-epoxy-8-methyltricyclo[5.2.1.0^{2,6}]deca-8-ene, 4,5-epoxy-8-trifluoromethyltricyclo[5.2.1.0^{2,6}]deca-8-ene, and the like. Among these, DCPME is preferred. In the polymerizable composition used in the present invention, the content of the derivative having an epoxy group is preferably 0.1 to 20% by mass, more preferably 0.5 to 10% by mass, still more preferably 1 to 5% by mass.

Examples of the monocyclic cycloolefin (a2) include, but should not be limited to, cyclobutene, cyclopentene, cyclohexene, cyclooctene, cyclododecene, cyclopentadiene, 1,4-cyclohexadiene, 1,5-cyclooctadiene, derivatives thereof having an alkyl group, an alkenyl group, an alkynyl group, an alkylidene group, an epoxy group, or an (meth)acrylic substitute (such as an ethylidene substitute), and the like. For example, 1,4-p-menthadiene can be suitably used as a derivative of 1,4-cyclohexadiene. The monocyclic cycloolefin (a2) is preferably a monocyclic cycloolefin having one or more unsaturated bonds showing metathesis reactivity in the molecule because it can further enhance the effects of the present invention. Examples of the monocyclic cycloolefin include 1,5-cyclooctadiene and derivatives thereof. These monocyclic cycloolefins (a2) can be used alone or in combination.

In the cycloolefin monomer used in the present invention, the content of the monocyclic cycloolefin (a2) is preferably 30 to 99% by mass, more preferably 30 to 80% by mass, still more preferably 30 to 60% by mass, further still more preferably 40 to 50% by mass relative to 1000 by mass of the entire cycloolefin monomer. By controlling the content of the monocyclic cycloolefin (a2) within the ranges above, a cycloolefin resin cured product having higher crack resistance and higher stretching properties can be obtained. Thus, temperature-cycle reliability and durability can be further enhanced when the cycloolefin resin cured product is used as a sealing material for semiconductor devices and the like, for example.

In the cycloolefin monomer used in the present invention, the content of the norbornene-based monomer (a1) is preferably 1 to 70% by mass, more preferably 20 to 70% by mass, still more preferably 40 to 70% by mass, further still more preferably 50 to 60% by mass relative to 1000 by mass of the entire cycloolefin monomer. By controlling the content of the norbornene-based monomer (a1) within the ranges above, a cycloolefin resin cured product having higher crack resistance and higher stretching properties can be obtained. Thus, temperature-cycle reliability and durability can be further enhanced when the cycloolefin resin cured product is used as a sealing material for semiconductor devices and the like, for example.

The polymerizable composition used in the present invention may also contain a different cycloolefin monomer (a3) in addition to the norbornene-based monomer (a1) and the monocyclic cycloolefin (a2).

In the cycloolefin monomer used in the present invention, the content of the different cycloolefin monomer (a3) is preferably 70% by mass or less, more preferably 50% by mass or less relative to 100% by mass of the entire cycloolefin monomer.

The metathesis polymerization catalyst used in the present invention can be any metathesis polymerization catalyst as long as it can ring-opening polymerize the cycloolefin monomer, and known metathesis polymerization catalysts can be used.

The metathesis polymerization catalyst used in the present invention is a complex having a transition metal atom as a central atom to which a plurality of ions, atoms, polyatomic ions, and/or compounds are bonded. As the transition metal atoms, atoms of Groups 5, 6, and 8 (Long Periodic Table, hereinafter, the same is applied) are used. Although there is no particular limitation to the atoms of the respective groups, examples of atoms of Group 5 include tantalum, examples of those of Group 6 include molybdenum and tungsten, and examples of those of Group 8 include ruthenium and osmium. Among these transition metal atoms, preferred are ruthenium and osmium of Group 8. That is, the metathesis polymerization catalyst used in the present invention is preferably a complex having ruthenium or osmium as the central atom, more preferably a complex having ruthenium as the central atom. The complex having ruthenium as the central atom is preferably a ruthenium carbene complex in which a carbene compound is coordinated with ruthenium. Here, the "carbene compound" is a generic name for a compound having a methylene free radical, and refers to a compound having an uncharged divalent carbon atom (carbene carbon) represented by (>C:). Because the ruthenium carbene complex has high catalytic activity during bulk ring-opening polymerization, a high-quality polymer having a low odor derived from unreacted monomers is prepared with high productivity. The ruthenium carbene complex, which is relatively stable to oxygen or moisture in the air and is hardly deactivated, can also be used under the air. These metathesis polymerization catalysts may be used alone or in combination.

Examples of the ruthenium carbene complex include those represented by General Formula (1) or (2) below:

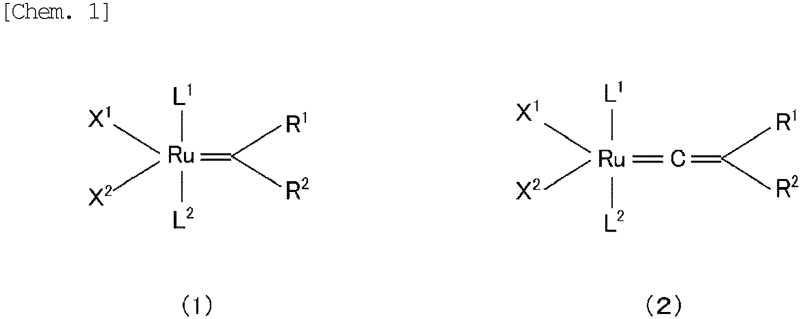

In General Formulae (1) and (2) above, R¹ and R² are each independently a hydrogen atom; a halogen atom; or a C₁ to C₂₀ organic group which may contain a halogen atom, an oxygen atom, a nitrogen atom, a sulfur atom, a phosphorus atom, or a silicon atom; and these groups may be substituted, or may be bonded to each other to form a ring. Examples of R¹ and R² bonded to each other to form a ring include indenylidene groups which may be substituted, such as a phenylindenylidene group.

Specific examples of the C₁ to C₂₀ organic group which may contain a halogen atom, an oxygen atom, a nitrogen atom, a sulfur atom, a phosphorus atom, or a silicon atom include C₁ to C₂₀ alkyl groups, C₂ to C₂₀ alkenyl groups, C₂ to C₂₀ alkynyl groups, C₆ to C₂₀ aryl groups, C₁ to C₂₀ alkoxy groups, C₂ to C₂₀ alkenyloxy groups, C₂ to C₂₀ alkynyloxy groups, C₆ to C₂₀ aryloxy groups, C₁ to C₈ alkylthio groups, a carbonyloxy group, C₁ to C₂₀ alkoxycarbonyl groups, C₁ to C₂₀ alkylsulfonyl groups, C₁ to C₂₀ alkylsulfinyl groups, C₁ to C₂₀ alkylsulfonic acid groups, C₆ to C₂₀ aryl sulfonic acid groups, a phosphonic acid group, C₆ to C₂₀ arylphosphonic acid groups, C₁ to C₂₀ alkylammonium groups, C₆ to C₂₀ arylammonium groups, and the like. These C₁ to C₂₀ organic groups which may contain a halogen atom, an oxygen atom, a nitrogen atom, a sulfur atom, a phosphorus atom, or a silicon atom may be substituted. Examples of substituents include C₁ to C₁₀ alkyl groups, C₁ to C₁₀ alkoxy groups, C₆ to C₁₀ aryl groups, and the like.

X¹ and X² each independently represent any anionic ligand. The anionic ligand is a ligand having a negative charge when separated from a central metal atom, and examples thereof include halogen atoms, diketonate groups, substituted cyclopentadienyl groups, alkoxyl groups, aryloxy groups, a carboxyl group, and the like.

L¹ and L² represent a heteroatom-containing carbene compound or a neutral electron-donating compound other than the heteroatom-containing carbene compound. The heteroatom-containing carbene compound and the neutral electron-donating compound other than the heteroatom-containing carbene compound are compounds having neutral charge when separated from the central metal. To improve catalytic activity, a heteroatom-containing carbene compound is preferred. The heteroatom indicates atoms of Groups 15 and 16 in the Periodic Table, and examples thereof specifically include a nitrogen atom, an oxygen atom, a phosphorus atom, a sulfur atom, an arsenic atom, a selenium atom, and the like. Among these, preferred are a nitrogen atom, an oxygen atom, a phosphorus atom, and a sulfur atom, and more preferred is a nitrogen atom to obtain a stable carbene compound.

The heteroatom-containing carbene compound is preferably a compound represented by General Formula (3) or (4) below. To improve catalytic activity, more preferred is a compound represented by General Formula (3) below:

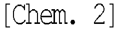

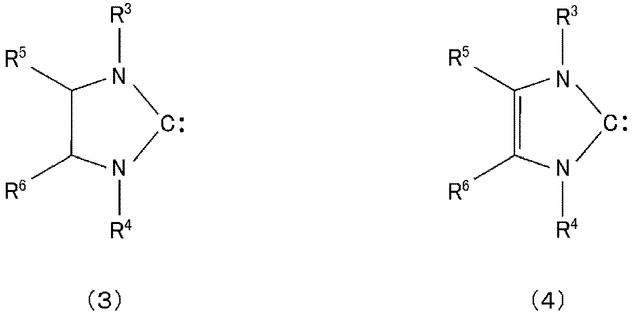

In General Formulae (3) and (4) above, R³, R⁴, R⁵, and R⁶ each independently represent a hydrogen atom; a halogen atom; or a C₁ to C₂₀ organic group which may contain a halogen atom, an oxygen atom, a nitrogen atom, a sulfur atom, a phosphorus atom, or a silicon atom. Specific examples of the C₁ to C₂₀ organic group which may contain a halogen atom, an oxygen atom, a nitrogen atom, a sulfur atom, a phosphorus atom, or a silicon atom are the same as those in General Formulae (1) and (2) above.
R³, R⁴, R⁵, and R⁶ may also be bonded to each other in any combination to form a ring.

Since the effects of the present invention become more prominent, R⁵ and R⁶ are preferably a hydrogen atom. R³ and R⁴ are preferably an aryl group which may be substituted, more preferably a phenyl group having a C₁ to C₁₀ alkyl group as a substituent, still more preferably a mesityl group.

Examples of the neutral electron-donating compound include an oxygen atom, water, carbonyls, ethers, nitriles, esters, phosphines, phosphinites, phosphites, sulfoxides, thioethers, amides, imines, aromatics, cyclic diolefins, olefins, isocyanides, thiocyanates, and the like.

In General Formulae (1) and (2) above, R¹, R², X¹, X², L¹, and L² may stand alone and/or may be bonded to each other in any combination to form a multidentate chelating ligand.

Among the compounds represented by General Formula (1) or (2) above, preferred are compounds represented by General Formula (1) above as the ruthenium carbene complex used in the present invention, since the effects of the present invention become more prominent. Among these, more preferred are compounds represented by General Formula (5) or (6) shown below.

General Formula (5) is shown below:

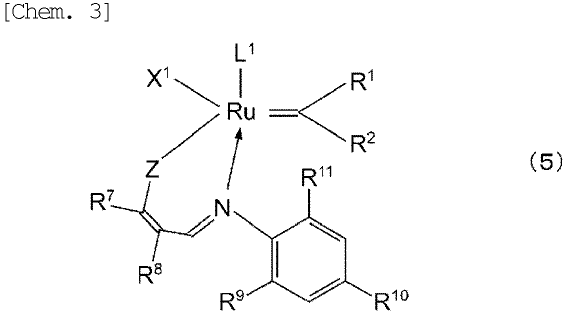

In General Formula (5) above, Z is an oxygen atom, a sulfur atom, a selenium atom, NR¹², PR¹², or AsR¹²; and R¹² is a hydrogen atom, a halogen atom, or a C₁ to C₂₀ organic group which may contain a halogen atom, an oxygen atom, a nitrogen atom, a sulfur atom, a phosphorus atom, or a silicon atom. Since the effects of the present invention become more prominent, Z is preferably an oxygen atom.

R¹, R², X¹, and L¹ are the same as those in General Formulae (1) and (2) above, and may stand alone and/or may be bonded to each other in any combination to form a multidentate chelating ligand. It is preferred that X¹ and L¹ do not form a multidentate chelating ligand and R¹ and R² be bonded to each other to form a ring, which is more preferably an indenylidene group which may be substituted, still more preferably a phenylindenylidene group.

Specific examples of the C₁ to C₂₀ organic group which may contain a halogen atom, an oxygen atom, a nitrogen atom, a sulfur atom, a phosphorus atom, or a silicon atom are the same as those in General Formulae (1) and (2) above.

In General Formula (5) above, R⁷ and R⁸ are each independently a hydrogen atom, a C₁ to C₂₀ alkyl group, a C₂ to C₂₀ alkenyl group, or a C₆ to C₂₀ heteroaryl group. These groups may be substituted, or may be bonded to each other to form a ring. Examples of the substituent include C₁ to C₁₀ alkyl groups, C₁ to C₁₀ alkoxy groups, or C₆ to C₁₀ aryl groups. Although the ring when it is formed by R⁷ and R⁸ may be any one of an aromatic ring, an alicyclic ring, and a heterocyclic ring, R⁷ and R⁸ form preferably an aromatic ring, more preferably a C₆ to C₂₀ aromatic ring, still more preferably a C₆ to C₁₀ aromatic ring.

In General Formula (5) above, R⁹, R¹⁰, and R¹¹ are each independently a hydrogen atom, a halogen atom, or a C₁ to C₂₀ organic group which may contain a halogen atom, an oxygen atom, a nitrogen atom, a sulfur atom, a phosphorus atom, or a silicon atom. These groups may be substituted, or may be bonded to each other to form a ring. Specific examples of the C₁ to C₂₀ organic group which may contain a halogen atom, an oxygen atom, a nitrogen atom, a sulfur atom, a phosphorus atom, or a silicon atom are the same as those in General Formulae (1) and (2) above.

R⁹, R¹⁰, and R¹¹ are preferably a hydrogen atom or a C₁ to C₂₀ alkyl group, more preferably a hydrogen atom or a C₁ to C₃ alkyl group.

Specific examples of the compound represented by General Formula (5) above and a method for producing the same include those described in WO 2003/062253 (JP 2005-515260 T).

General Formula (6) is shown below:

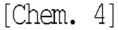

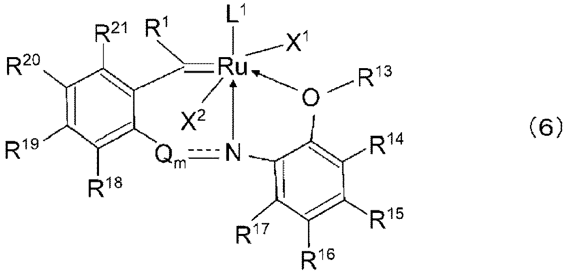

In General Formula (6) above, m is 0 or 1. m is preferably 1, and in this case, Q is an oxygen atom, a nitrogen atom, a sulfur atom, a methylene group, an ethylene group, or a carbonyl group, preferably a methylene group.

In General Formula (6) above, 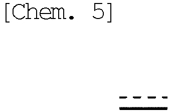 is a single bond or a double bond, preferably a single bond.

R¹, X¹, X², and L¹ are the same as those in General Formulae (1) and (2) above, and may stand alone and/or may be bonded to each other in any combination to form a multidentate chelating ligand. Preferably, X¹, X², and L¹ do not form a multidentate chelating ligand and R¹ is a hydrogen atom.

R¹³ to R²¹ are a hydrogen atom, a halogen atom, or a C₁ to C₂₀ organic group which may contain a halogen atom, an oxygen atom, a nitrogen atom, a sulfur atom, a phosphorus atom, or a silicon atom. These groups may be substituted, or may be bonded to each other to form a ring. Specific examples of the C₁ to C₂₀ organic group which may contain a halogen atom, an oxygen atom, a nitrogen atom, a sulfur atom, a phosphorus atom, or a silicon atom are the same as those in General Formulae (1) and (2) above.

R¹³ is preferably a C₁ to C₂₀ alkyl group, more preferably a C₁ to C₃ alkyl group. R¹⁴ to R¹⁷ are preferably a hydrogen atom, and R¹⁸ to R²¹ are preferably a hydrogen atom or a halogen atom.

Specific examples of the compound represented by General Formula (6) above and a method for producing the same include those described in WO 2011/079799 (JP 2013-516392 T).

The content of the metathesis polymerization catalyst is preferably 0.005 mmol or more, more preferably 0.01 to 50 mmol, still more preferably 0.015 to 20 mmol relative to 1 mol of the total cycloolefin monomers used in the reaction.

The polymerizable composition used in the present invention may also contain a radical generator, a diisocyanate compound, a polyfunctional (meth)acrylate compound, and other optional components when needed.

The radical generator, when heated, generates radicals, by which the radical generator induces a cross-linking reaction in a cycloolefin polymer formed through bulk polymerization. Moieties of the cross-linking reaction induced by the radical generator are mainly carbon-carbon double bonds of the cycloolefin monomer while moieties of saturated bonds may be cross-linked in some cases.

Examples of the radical generator include organic peroxides, diazo compounds, and nonpolar radical generators. Examples of the organic peroxides include hydroperoxides such as t-butyl hydroperoxide, p-menthane hydroperoxide, and cumene hydroperoxide; dialkyl peroxides such as di-t-butyl peroxide, dicumyl peroxide, and t-butylcumyl peroxide; diacyl peroxides such as dipropionyl peroxide and benzoyl peroxide; peroxy ketals such as 2,5-dimethyl-2,5-di(t-butylperoxy)hexane, 2,5-dimethyl-2,5-di(t-butylperoxy)-3-hexyne, and 1,3-di(t-butylperoxyisopropyl)benzene; peroxy esters such as t-butylperoxy acetate and t-butylperoxy benzoate; peroxy carbonates such as t-butylperoxyisopropyl carbonate and di(isopropyl peroxy)dicarbonate; alkylsilyl peroxides such as t-butyltrimethylsilyl peroxide; and the like. Among these, preferred are dialkyl peroxides particularly because they hardly obstruct the metathesis polymerization reaction in the bulk polymerization.

Examples of the diazo compounds include 4,4'-bisazidobenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenylsulfone, 4,4'-diazidodiphenylmethane, 2,2'-diazidostilbene, and the like.

Examples of the nonpolar radical generators include 2,3-dimethyl-2,3-diphenylbutane, 2,3-diphenylbutane, 1,4-diphenylbutane, 3,4-dimethyl-3,4-diphenylhexane, 1,1,2,2-tetraphenylethane, 2,2,3,3-tetraphenylbutane, 3,3,4,4-tetraphenylhexane, 1,1,2-triphenylpropane, 1,1,2-triphenylethane, triphenylmethane, 1,1,1-triphenylethane, 1,1,1-triphenylpropane, 1,1,1-triphenylbutane, 1,1,1-triphenylpentane, 1,1,1-triphenyl-2-propene, 1,1,1-triphenyl-4-pentene, 1,1,1-triphenyl-2-phenylethane, and the like.

The amount of the radical generator in the polymerizable composition used in the present invention is preferably 0.1 to 10 parts by mass, more preferably 0.5 to 5 parts by mass relative to 100 parts by mass of the total cycloolefin monomers used.

Examples of the diisocyanate compounds include aromatic diisocyanate compounds such as methylenediphenyl 4,4'-diisocyanate (MDI), toluene-2,4-diisocyanate, 4-methoxy-1,3-phenylene diisocyanate, 4-isopropyl-1,3-phenylene diisocyanate, 4-chloro-1,3-phenylene diisocyanate, 4-butoxy-1,3-phenylene diisocyanate, 2,4-diisocyanate diphenyl ether, 1,4-phenylene diisocyanate, tolylene diisocyanate, xylylene diisocyanate (XDI), 1,5-naphthalene diisocyanate, benzidine diisocyanate, o-nitrobenzidine diisocyanate, and 4,4'-diisocyanate dibenzyl; aliphatic diisocyanate compounds such as methylene diisocyanate, 1,4-tetramethylene diisocyanate, 1,6-hexamethylene diisocyanate, and 1,10-decamethylene diisocyanate; alicyclic diisocyanate compounds, such as 4-cyclohexylene diisocyanate, 4,4'-methylene bis(cyclohexyl isocyanate), 1,5-tetrahydronaphthalene diisocyanate, isophorone diisocyanate, hydrogenated MDI, and hydrogenated XDI; polyurethane prepolymers terminated with isocyanate, which are prepared by reacting these diisocyanate compounds with a low molecular weight polyol or polyamine; and the like. In addition, known isocyanurate forms, biuret forms, adduct forms, or polymeric forms of these compounds, which have a polyfunctional isocyanate group and are conventionally used, can be used without limitation. Examples thereof include dimers of 2,4-toluylene diisocyanate, triphenylmethane triisocyanate, tris-(p-isocyanate phenyl)thio phosphite, polyfunctional aromatic isocyanate compounds, polyfunctional aromatic aliphatic isocyanate compounds, polyfunctional aliphatic isocyanate compounds, fatty acid modified-polyfunctional aliphatic isocyanate compounds, block-type polyfunctional isocyanate compounds such as blocked polyfunctional aliphatic isocyanate compounds, polyisocyanate prepolymers, and the like. Among these, suitably used are aromatic diisocyanate compounds, aliphatic diisocyanate compounds, and alicyclic diisocyanate compounds, which are non-block-type polyfunctional isocyanate compounds, because of their availability and ease in handling.

These compounds can be used alone or in combination.

The block-type polyfunctional isocyanate compound indicates an isocyanate compound having at least two isocyanate groups in the molecule which are inactivated at normal temperature through a reaction with an active hydrogen-containing compound. The isocyanate compound usually has a structure having isocyanate groups masked with a blocking agent, examples of the blocking agent including alcohols, phenols, ε-caprolactam, oximes, active methylene compounds, and the like. The block-type polyfunctional isocyanate compound is usually not reactive at normal temperature, leading to high storage stability, while it exhibits high reactivity due to the isocyanate groups regenerated when heated usually at 140 to 200°C.

It is considered that when used in combination with a polyfunctional (meth)acrylate compound, the diisocyanate compound forms chemical bonds between active hydrogen reactive groups in the molecule and hydroxyl groups present in the polyfunctional (meth)acrylate compound, and as a result, improves adhesion between the cycloolefin monomer and a substrate (e.g., a semiconductor element in applications to a sealing material for semiconductor elements).

These diisocyanate compounds may be used alone or in combination. The compounding amount of the diisocyanate compound in the polymerizable composition used in the present invention is preferably 0.5 to 20 parts by mass, more preferably 1 to 15 parts by mass, still more preferably 2 to 10 parts by mass relative to 100 parts by mass of the total cycloolefin monomers. These ranges are preferred because the resulting cycloolefin resin cured product can have favorable strength and heat resistance while having improved adhesion.

To further enhance the adhesion to a substrate (e.g., a semiconductor element when the cycloolefin resin cured product is used as a sealing material for semiconductor elements), a polyfunctional (meth)acrylate compound may be used. It is inferred that when the compound is used in combination with the diisocyanate compound, the function of the diisocyanate compound as an adhesion improver or an adhesion imparting agent is synergistically enhanced. Preferred examples of polyfunctional (meth)acrylate compounds include ethylene glycol dimethacrylate, triethylene glycol dimethacrylate, trimethylolpropane trimethacrylate, and neopentyl glycol dimethacrylate.

These polyfunctional (meth)acrylate compounds may be used alone or in combination. The compounding amount of the polyfunctional (meth)acrylate compound is preferably 0.5 to 20 parts by mass, more preferably 1 to 15 parts by mass, still more preferably 2 to 10 parts by mass relative to 100 parts by mass of the total cycloolefin monomers used. These ranges are preferred because the function of the diisocyanate compound as an adhesion improver or an adhesion imparting agent is synergistically enhanced, resulting in further enhanced adhesion of the cycloolefin resin cured product.

Examples of other optional components include activating agents, activity regulators, elastomers, antioxidants, and the like.

The activating agent is a compound which acts as a cocatalyst for the above-mentioned metathesis polymerization catalyst to improve the polymerization activity of the catalyst. Examples of activating agents to be used include alkylaluminum halides such as ethylaluminum dichloride, and diethylaluminum chloride; alkoxyalkylaluminum halides prepared by substituting part of alkyl groups in these alkylaluminum halides with an alkoxy group; organic tin compounds, and the like. The activating agent can be used in any amount, and the amount is preferably 0.1 to 100 mol, more preferably 1 to 10 mol relative to 1 mol of the total metathesis polymerization catalysts used in the polymerizable composition.

As described later, when two or more reaction stock solutions are mixed to prepare a polymerizable composition, the polymerization composition is injected into a mold, and polymerization is initiated, the activity regulator is used to prevent the polymerization from starting during the injection.

When a compound of a transition metal in Group 5 or 6 in the Periodic Table is used as the metathesis polymerization catalyst, examples of activity regulators include compounds having action to reduce the metathesis polymerization catalyst, and the like. Alcohols, haloalcohols, esters, ethers, nitriles, and the like can be used. Among these, preferred are alcohols and haloalcohols, and more preferred are haloalcohols.

Specific examples of alcohols include n-propanol, n-butanol, n-hexanol, 2-butanol, isobutyl alcohol, isopropyl alcohol, t-butyl alcohol, and the like. Specific examples of haloalcohols include 1,3-dichloro-2-propanol, 2-chloroethanol, 1-chlorobutanol, and the like.

In particular, when a ruthenium carbene complex is used as the metathesis polymerization catalyst, examples of the activity regulator include Lewis base compounds. Examples of the Lewis base compounds include Lewis base compounds containing a phosphorus atom, such as tricyclopentyl phosphine, tricyclohexyl phosphine, triphenyl phosphine, triphenyl phosphite, and n-butyl phosphine; Lewis base compounds containing a nitrogen atom, such as n-butylamine, pyridine, 4-vinylpyridine, acetonitrile, ethylenediamine, N-benzylidenemethylamine, pyrazine, piperidine, and imidazole; and the like. In addition, norbornenes substituted by an alkenyl group, such as vinyl norbornene, propenyl norbornene, and isopropenyl norbornene, are the cycloolefin monomer described above and also act as the activity regulator. The amount of these activity regulators to be used may be appropriately adjusted depending on the compound to be used.

Examples of the elastomers include natural rubber, polybutadiene, polyisoprene, styrene-butadiene copolymers (SBR), styrene-butadiene-styrene copolymers (SBS), styrene-isoprene-styrene copolymers (SIS), ethylene-propylene-diene terpolymers (EPDM), ethylene-vinyl acetate copolymers (EVA), hydrides thereof, and the like. The viscosity of the elastomer can be adjusted for use by dissolving the elastomer in the polymerizable composition. By adding the elastomer, a composite material molded body having improved impact resistance can be obtained. The amount of the elastomer to be used is preferably 0.5 to 20 parts by mass, more preferably 2 to 10 parts by mass relative to 100 parts by mass of the total cycloolefin monomers in the polymerizable composition.

Examples of the antioxidants include antioxidants for a variety of plastics and rubbers, such as phenol-based, phosphorus-based, and amine-based antioxidants.

The polymerizable composition used in the present invention may also contain a filler as an optional component. A variety of fillers can be used as the filler without limitation, and a particulate inorganic filler is preferably used.

The particulate inorganic filler is preferably that having an aspect ratio of 1 to 2, and is more preferably that having an aspect ratio of 1 to 1.5. The particulate inorganic filler has a 50% volume cumulative diameter of preferably 0.1 to 50 µm, more preferably 1 to 30 µm, particularly preferably 1 to 10 µm. Here, the aspect ratio indicates the ratio of the average major axis diameter of the filler to the 50% volume cumulative diameter thereof. The average major axis diameter indicates the number average major axis diameter obtained by measuring major axis diameters of 100 filler particles selected at random in an optical microscope image and calculating the arithmetic average thereof. The 50% volume cumulative diameter is a value determined by measuring the particle size distribution by an X-ray transmission method.

Specific examples of the particulate inorganic filler include calcium carbonate, calcium hydroxide, calcium silicate, calcium sulfate, aluminum hydroxide, magnesium hydroxide, titanium oxide, zinc oxide, barium titanate, silica, alumina, carbon black, graphite, antimony oxide, red phosphorus, a variety of metal powders, clay, a variety of ferrites, hydrotalcite, and the like. Among these, preferred are magnesium hydroxide, aluminum hydroxide, silica, and alumina, and particularly preferred are aluminum hydroxide and silica.

The particulate inorganic filler may have a hydrophobized surface. When a hydrophobized particulate inorganic filler is used, aggregation and sedimentation of the particulate inorganic filler in the polymerizable composition can be prevented, and the particulate inorganic filler can be homogeneously dispersed in the resulting cycloolefin resin cured product. As a result, the stretching properties of the cycloolefin resin cured product can be enhanced. Examples of a treatment agent used in the hydrophobization include silane coupling agents such as vinylsilane, titanate coupling agents, aluminum coupling agents, fatty acids such as stearic acid, oils and fats, surfactants, waxes, and the like.

A preferred treatment agent is a silane coupling agent having at least one hydrocarbon group having a norbornene structure because the polymerizable composition, even when compounded with the filler, has a low viscosity, has thixotropy (viscosity in a static state) which is unlikely to increase, and can improve the adhesion to a substrate (e.g., a semiconductor element in applications to a sealing material for semiconductor elements). Although the silane coupling agent can also function as a monomer, the silane coupling agent is handled as a coupling agent in the present invention. Specific examples of such a silane coupling agent include bicycloheptenylethyltrimethoxysilane, bicycloheptenylethyltriethoxysilane, bicycloheptenylhexyltrimethoxysilane, bicycloheptenylhexyltriethoxysilane, and the like. Preferred are bicycloheptenylethyltriethoxysilane and bicycloheptenylhexyltrimethoxysilane.

The content of the silane coupling agent having at least one hydrocarbon group having a norbornene structure is preferably 0.1 to 5% by mass, more preferably 0.3 to 2% by mass, still more preferably 0.5 to 1% by mass in the polymerizable composition used in the present invention.

The compounding amount of the particulate inorganic filler in the polymerizable composition used in the present invention is preferably 10 to 1000 parts by mass, more preferably 100 to 500 parts by mass relative to 100 parts by mass of the cycloolefin monomer.

In addition to the particulate inorganic filler, the polymerizable composition used in the present invention may contain a fibrous inorganic filler. The fibrous inorganic filler is preferably that having an aspect ratio of 5 to 100, and is more preferably that having an aspect ratio of 10 to 50. The fibrous inorganic filler has a 50% volume cumulative diameter of preferably 0.1 to 50 µm, more preferably 1 to 30 µm.

Specific examples of the fibrous inorganic filler include glass fibers, wollastonite, potassium titanate, Zonolite, basic magnesium sulfate, aluminum borate, tetrapod-shaped zinc oxide, gypsum fibers, phosphate fibers, alumina fibers, whisker-like calcium carbonate, whisker-like boehmite, and the like. Among these, preferred are wollastonite and whisker-like calcium carbonate. The fibrous inorganic filler may also have a hydrophobized surface as in the case of the particulate inorganic filler described above.

The polymerizable composition used in the present invention is prepared by appropriately mixing the components above by a known method. The polymerizable composition used in the present invention may be prepared by preparing two or more preparative liquid formulations, and mixing the two or more preparative liquid formulations with a mixing apparatus immediately before formation of the cycloolefin resin cured product. For the preparative liquid formulations, the above-mentioned components are distributed and prepared into two or more solutions such that each of them alone is not capable of bulk polymerization, and when all the solutions are mixed, they can form the polymerizable composition containing the above-mentioned components in predetermined proportions. Examples of a combination of such two or more reaction stock solutions include two combinations (a) and (b) below depending on the type of the metathesis polymerization catalyst used.
(a): The metathesis polymerization catalyst to be used can be a metathesis polymerization catalyst which alone has no polymerization reaction activity while exhibiting polymerization reaction activity when used in combination with the activating agent. In this case, a preparative liquid formulation (solution A) containing the cycloolefin monomer and the activating agent and a preparative liquid formulation (solution B) containing the cycloolefin monomer and the metathesis polymerization catalyst are used, and the polymerizable composition can be prepared by mixing these. Furthermore, a preparative liquid formulation (solution C) containing a cycloolefin monomer but not any of the metathesis polymerization catalyst and the activating agent may be used in combination.
(b): When a metathesis polymerization catalyst which alone has polymerization reaction activity is used, the polymerizable composition can be prepared by mixing a preparative liquid formulation (i) containing the cycloolefin monomer and a preparative liquid formulation (ii) containing the metathesis polymerization catalyst. At this time, the preparative liquid formulation (ii) to be used is usually in the form of a dissolution or dispersion of the metathesis polymerization catalyst in a small amount of an inert solvent. Examples of such a solvent include aromatic hydrocarbons such as toluene, xylene, ethylbenzene, and trimethylbenzene; ketones such as methyl ethyl ketone, cyclopentanone, cyclohexanone, 2-heptanone, and 4-hydroxy-4-methyl-2-pentanone; cyclic ethers such as tetrahydrofuran; diethyl ether, dichloromethane, dimethyl sulfoxide, ethyl acetate, and the like. Preferred are aromatic hydrocarbons, and more preferred is toluene.

The optional components such as the radical generator, the diisocyanate compound, and the polyfunctional (meth)acrylate compound may be contained in any one of the preparative liquid formulations, or may be added in the form of a mixed solution other than the preparative liquid formulations.

Examples of the mixing apparatus used in mixing of the preparative liquid formulations above include collision mixing apparatuses usually used in reaction injection molding, low pressure mixers such as dynamic mixers and static mixers, and the like.

### <Cycloolefin resin cured product>

The cycloolefin resin cured product according to the present invention is obtained through bulk polymerization of the polymerizable composition described above, and has an elongation at break at 23°C of 30% or more.

Examples of a method of producing the cycloolefin resin cured product according to the present invention include a method of individually introducing the above-mentioned two or more preparative liquid formulations to a collision mixing apparatus, and instantaneously mixing these with a mixing head, followed by bulk polymerization in a mold or on a substrate; and the like.

For example, when the cycloolefin resin cured product according to the present invention is used as a sealing material for sealing semiconductor elements such as power semiconductor elements, by individually introducing the above-mentioned two or more preparative liquid formulations to the collision mixing apparatus, instantaneously mixing these with the mixing head, and feeding the mixed solution from the mixing head to cover the surface(s) of (a) semiconductor element(s), a semiconductor device including the semiconductor element(s) sealed with the cycloolefin resin cured product according to the present invention can be obtained.

Moreover, the cycloolefin resin cured product according to the present invention has an elongation at break at 23°C of 30% or more, more preferably 50% or more, still more preferably 1000 or more. The upper limit of the elongation at break is not particularly limited, and is 1000% or less, for example. The elongation at break of the cycloolefin resin cured product can be determined as follows: The cycloolefin resin cured product is formed into a # A1 dumbbell shape in accordance with JIS K7161, and the dumbbell-shaped test piece is subjected to a tensile test at a distance between chucks of 110 mm, a tensile rate of 50 mm/s, a gauge length of 75 mm, and a temperature of 23°C according to JIS K7161 to measure the elongation at break.

Although the cycloolefin resin cured product according to the present invention may have an elongation at break at 23°C within these ranges above, its elongation at break at -25°C is preferably 7% or more, more preferably 30% or more, still more preferably 50% or more, further still more preferably 1000 or more. The upper limit of the elongation at break at -25°C is not particularly limited, and is 1000% or less, for example. The elongation at break at -25°C can be measured in the same manner as in the case of the elongation at break at 23°C except that the temperature condition is changed to -25°C.

The elongation at break at 23°C of the cycloolefin resin cured product according to the present invention after stored at 155°C for 1000 hours is preferably 7% or more, more preferably 20% or more, still more preferably 28% or more, further still more preferably 50% or more. The upper limit thereof is not particularly limited, and is 500% or less, for example. The elongation at break at 23°C after storing at 155°C for 1000 hours can be determined by storing the cycloolefin resin cured product at 155°C for 1000 hours, and measuring the elongation at break at 23°C by the method described above.

The present invention can provide a cycloolefin resin cured product having high stretching properties and excellent high-temperature durability as well as sufficient crack resistance, by using a combination of the norbornene-based monomer (a1) and the monocyclic cycloolefin (a2) as the cycloolefin monomer and controlling the elongation at break at 23°C within these ranges above. Thus, when the cycloolefin resin cured product according to the present invention is used in applications of electrical sealing, especially, as a sealing material for resin sealing-type semiconductor devices, the temperature-cycle reliability and durability of semiconductor devices produced using this sealing material can be enhanced. In particular, because semiconductor devices produced using the cycloolefin resin cured product according to the present invention as a sealing material have excellent temperature-cycle reliability and high durability, these can achieve sufficient reliability and durability even under environments in which power semiconductor elements (for example, power semiconductor elements including a wide bandgap material such as SiC, GaN, Ga₂O₃, or diamond) are used. For this reason, these semiconductor devices are particularly suitable as semiconductor devices including a power semiconductor element as a semiconductor element. The cycloolefin resin cured product according to the present invention, which is prepared using the cycloolefin monomer, also has the properties of the cycloolefin resin, that is, low viscosity of its monomer solution which leads to great forming freedom and short-time applicability and curability.

Due to its high crack resistance, high stretching properties, and excellent high-temperature durability, the cycloolefin resin cured product according to the present invention can be used as an sealing material for resin sealing-type semiconductor devices, and can also be suitably used in applications to formation of metal composites, more specifically, in applications as coating of members which have a metal portion on their surfaces and are disposed under environments with significant temperature changes, such as applications as coating of pipeline joints (applications as coating of welded connection portions of pipeline joints). In particular, in applications as coating of pipeline joints in which curing in a short time is desired, the cycloolefin resin cured product according to the present invention is suitable because the properties of the cycloolefin resin, that is, short-time applicability and curability are sufficiently utilized. Furthermore, besides these applications, utilizing its high crack resistance, high stretching properties, and excellent high-temperature durability, the cycloolefin resin cured product according to the present invention can also be suitably used in applications to vehicles such as bumpers and air deflectors, construction and industrial machinery applications such as wheel loaders and power shovels, leisure applications such as golf carts and game machines, medical applications such as medical apparatuses, industrial applications such as large panels and chairs, household equipment applications such as shower pans and lavatory bowls, and the like.

### EXAMPLES

Hereinafter, the present invention will be described by way of Examples, but these Examples should not be construed as limitations to the present invention. To be noted, "parts" and "%" are mass-based unless otherwise specified. Tests and evaluations were performed as follows.

### <Elongation at break (normal temperature)>

Dumbbell-shaped test pieces were prepared by punching cycloolefin resin cured products into #A1 dumbbell shapes in accordance with JIS K7161. The resulting dumbbell-shaped test pieces were subjected to a tensile test according to JIS K7161 at a distance between chucks of 110 mm, a tensile rate of 50 mm/s, a gauge length of 75 mm, and a temperature of 23°C, and were measured for the elongation at break. Thereby, the elongation at break at normal temperature was determined.

### <Elongation at break (-25°C)>

Dumbbell-shaped test pieces were prepared by punching cycloolefin resin cured products into #A1 dumbbell shapes in accordance with JIS K7161. The resulting dumbbell-shaped test pieces were subjected to a tensile test according to JIS K7161 at a distance between chucks of 110 mm, a tensile rate of 50 mm/s, a gauge length of 75 mm, and a temperature of -25°C, and were measured for the elongation at break. Thereby, the elongation at break at -25°C was determined.

### <High-temperature durability>

Dumbbell-shaped test pieces were prepared by punching cycloolefin resin cured products into #A1 dumbbell shapes in accordance with JIS K7161. The resulting dumbbell-shaped test pieces were stored under a condition at 125°C for 1000 hours, under a condition at 155°C for 1000 hours, and under a condition at 175°C for 1000 hours. The test pieces after storing were measured for the elongation at break on the same conditions as those in "Elongation at break (normal temperature)" described above.

### <Example 1>

70 Parts of an RIM monomer (available from ZEON Corporation) and 30 parts of 1,5-cyclooctadiene were mixed to prepare a preparative liquid formulation (i). The RIM monomer contains 90 parts of dicyclopentadiene and 10 parts of tricyclopentadiene as the norbornene-based monomers.

0.3 Parts of a ruthenium catalyst (Zhan1N) represented by General Formula (7) as a metathesis polymerization catalyst, 30 parts of 2,6-di-t-butyl-p-cresol (BHT, antioxidant), and 30 parts of triphenylphosphine were dissolved in 39.7 parts of cyclopentanone to prepare a preparative liquid formulation (ii). 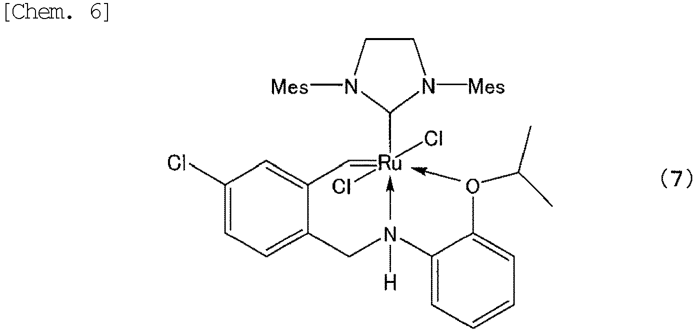 (where Mes represents a mesityl group.)

The mold for molding used was a mold for reaction injection molding of a flat plate molded article, which was composed of two stainless steel plates and had an inner space measuring 245 mm in length × 210 mm in width × 4 mm in thickness. The mold for reaction injection molding has a structure in which a reaction solution injection hole is disposed in the lowest portion of one of the stainless steel plates.

The preparative liquid formulation (i) and the preparative liquid formulation (ii) prepared above were mixed in a ratio (i):(ii) of 100:3.5 (mass ratio), and the mixed solution was defoamed in vacuum. Then, the mixed solution was injected from the reaction solution injection hole into the mold for reaction injection molding, and was heated in an oven heated to 40°C for 30 minutes and then at 175°C for 60 minutes to give a cycloolefin resin cured product which was polymerized and cured. The resulting cycloolefin resin cured product was measured and evaluated for the elongations at break (normal temperature and -25°C) and high-temperature durability. The results are shown in Table 1.

### <Example 2>

A cycloolefin resin cured product was prepared in the same manner as in Example 1 except that in preparation of the preparative liquid formulation (i), the compounding amount of the RIM monomer was changed to 60 parts and the compounding amount of 1,5-cyclooctadiene was changed to 40 parts, and was evaluated as described above. The results are shown in Table 1.

### <Example 3>

A cycloolefin resin cured product was prepared in the same manner as in Example 1 except that in preparation of the preparative liquid formulation (i), the compounding amount of the RIM monomer was changed to 50 parts and the compounding amount of 1,5-cyclooctadiene was changed to 50 parts, and was evaluated as described above. The results are shown in Table 1.

### <Example 4>

A cycloolefin resin cured product was prepared in the same manner as in Example 1 except that in preparation of the preparative liquid formulation (i), the compounding amount of the RIM monomer was changed to 30 parts and the compounding amount of 1,5-cyclooctadiene was changed to 70 parts, and was evaluated as described above. The results are shown in Table 1.

### <Example 5>

A cycloolefin resin cured product was prepared in the same manner as in Example 1 except that in preparation of the preparative liquid formulation (i), the compounding amount of the RIM monomer was changed to 10 parts and the compounding amount of 1,5-cyclooctadiene was changed to 90 parts, and was evaluated as described above. The results are shown in Table 1.

### <Example 6>

A cycloolefin resin cured product was prepared in the same manner as in Example 1 except that in preparation of the preparative liquid formulation (i), 1,5-cyclooctadiene was not compounded, the compounding amount of the RIM monomer was changed to 70 parts, and the compounding amount of cyclooctene was changed to 30 parts, and was evaluated as described above. The results are shown in Table 1.

### <Example 7>

A cycloolefin resin cured product was prepared in the same manner as in Example 1 except that in preparation of the preparative liquid formulation (i), 1,5-cyclooctadiene was not compounded, the compounding amount of the RIM monomer was changed to 50 parts, and the compounding amount of cyclooctene was changed to 50 parts, and was evaluated as described above. The results are shown in Table 1.

### <Example 8>

A cycloolefin resin cured product was prepared in the same manner as in Example 1 except that in preparation of the preparative liquid formulation (i), 1,5-cyclooctadiene was not compounded, the compounding amount of the RIM monomer was changed to 50 parts, and the compounding amount of cyclohexene was changed to 50 parts, and was evaluated as described above. The results are shown in Table 1.

### <Example 9>

A cycloolefin resin cured product was prepared in the same manner as in Example 1 except that in preparation of the preparative liquid formulation (i), 1,5-cyclooctadiene was not compounded, the compounding amount of the RIM monomer was changed to 70 parts, and the compounding amount of 1,4-p-menthadiene was changed to 30 parts, and was evaluated as described above. The results are shown in Table 1.

### <Example 10>

In preparation of the preparative liquid formulation (i), the compounding amount of the RIM monomer was changed to 14.5 parts, the compounding amount of 1,5-cyclooctadiene was changed to 14.5 parts, and 0.6 parts of a dicyclopentadiene monoepoxide (DCPME) solution and 0.4 parts of bicycloheptenylethyltrimethoxysilane were mixed. The DCPME solution was used as a cyclopentanone solution containing 5,6-DCPME and DCPDE (dicyclopentadiene diepoxide) as by-products (DCPME content: about 40%, by-products content: about 27%). 70 Parts of aluminum hydroxide (aspect ratio: 1, 50% volume cumulative diameter: 3 µm) was further compounded therewith to prepare a preparative liquid formulation (i). This preparative liquid formulation (i) prepared and the preparative liquid formulation (ii) were mixed in a ratio (i):(ii) of 100:1.1 (mass ratio). Except for these, a cycloolefin resin cured product was prepared in the same manner as in Example 1, and was evaluated as described above. The results are shown in Table 1.

### <Comparative Example 1>

A cycloolefin resin cured product was prepared in the same manner as in Example 1 except that in preparation of the preparative liquid formulation (i), the compounding amount of the RIM monomer was changed to 100 parts and 1,5-cyclooctadiene was not compounded, and was evaluated as described above. The results are shown in Table 1.

### <Comparative Example 2>

A cycloolefin resin cured product was prepared in the same manner as in Example 1 except that in preparation of the preparative liquid formulation (i), the compounding amount of the RIM monomer was changed to 90 parts and the compounding amount of 1,5-cyclooctadiene was changed to 10 parts, and was evaluated as described above. The results are shown in Table 1.

### <Comparative Example 3>

A cycloolefin resin cured product was prepared in the same manner as in Example 1 except that in preparation of the preparative liquid formulation (i), the compounding amount of the RIM monomer was changed to 80 parts and the compounding amount of 1,5-cyclooctadiene was changed to 20 parts, and was evaluated as described above. The results are shown in Table 1.

### <Comparative Example 4>

A cycloolefin resin cured product was prepared in the same manner as in Example 10 except that in preparation of the preparative liquid formulation (i), the compounding amount of the RIM monomer was changed to 29 parts and 1,5-cyclooctadiene was not compounded, and was evaluated as described above. The results are shown in Table 1.

### [Table 1]

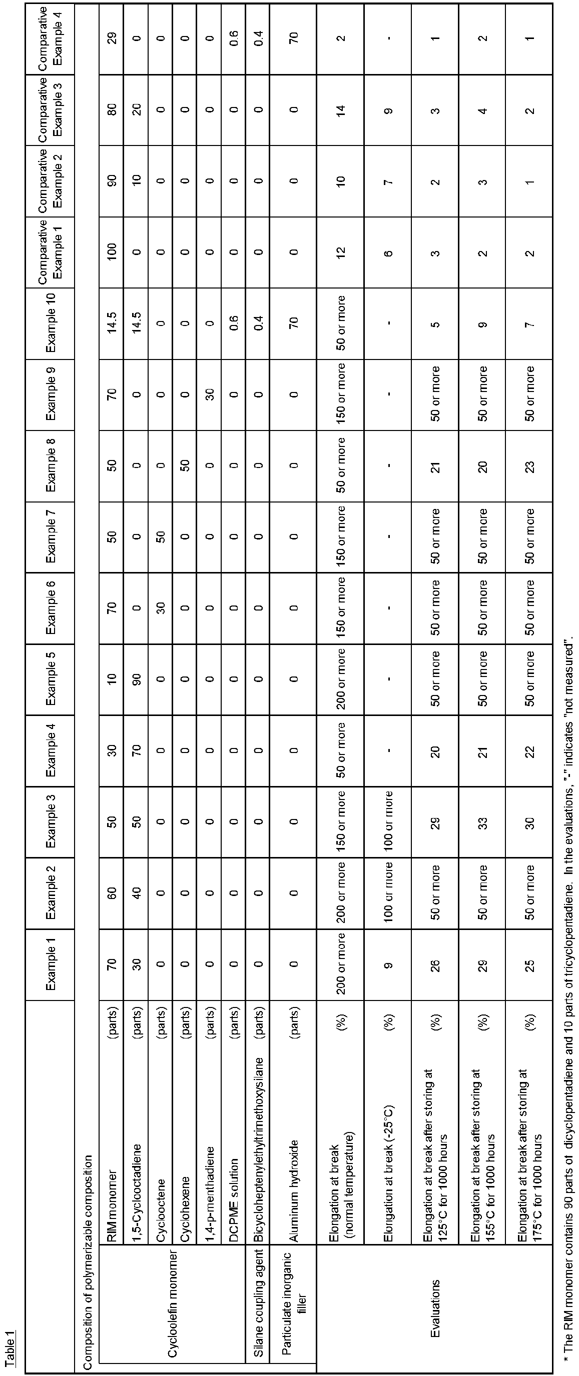

Table 1 shows that the cycloolefin resin cured products prepared from the polymerizable compositions containing the norbornene-based monomer (a1) and the monocyclic cycloolefin (a2) as the cycloolefin monomers and having an elongation at break at 23°C (normal temperature) of 30% or more exhibited a large elongation at break at normal temperature as well as a large elongation at break at -25°C, had a sufficient elongation at break after storing at high temperature, and had high crack resistance, high stretching properties, and excellent high-temperature durability. These results lead to a conclusion that the cycloolefin resin cured products can achieve excellent temperature-cycle reliability and excellent high-temperature durability when used as a sealing material for semiconductor elements (Examples 1 to 10).

In contrast, the elongation at break at -25°C and the elongation at break after storing at high temperature were reduced in the cases where the polymerizable composition without the monocyclic cycloolefin (a2) as the cycloolefin monomer was used and the cases where the elongation at break at 23°C (normal temperature) was less than 30% in spite of using the polymerizable composition including the monocyclic cycloolefin (a2) (Comparative Examples 1 to 4).

## Claims

1. A cycloolefin resin cured product formed through bulk polymerization of a polymerizable composition comprising a cycloolefin monomer and a metathesis polymerization catalyst,
wherein the cycloolefin monomer includes a norbornene-based monomer (a1) and a monocyclic cycloolefin (a2), and
the cycloolefin resin cured product has an elongation at break at 23°C of 30% or more.

2. The cycloolefin resin cured product according to claim 1,
wherein the content of the monocyclic cycloolefin (a2) in the cycloolefin monomer is 30 to 99% by mass.

3. The cycloolefin resin cured product according to claim 1 or 2, wherein the monocyclic cycloolefin (a2) is at least one selected from the group consisting of 1,5-cyclooctadiene, cyclooctene, cyclohexene, 1,4-cyclohexadiene, and 1,4-p-menthadiene.

4. The cycloolefin resin cured product according to claim 3,
wherein the monocyclic cycloolefin (a2) is 1,5-cyclooctadiene.

5. The cycloolefin resin cured product according to any one of claims 1 to 4, wherein the polymerizable composition contains a filler.

6. A polymerizable composition for forming the cycloolefin resin cured product according to claim 1, the polymerizable composition comprising a cycloolefin monomer and a metathesis polymerization catalyst,
wherein the cycloolefin monomer includes a norbornene-based monomer (a1) and a monocyclic cycloolefin (a2).

7. The polymerizable composition according to claim 6, wherein the polymerizable composition is in the form of two or more preparative liquid formulations each of which alone is not capable of polymerization, and can be formed by combining the preparative liquid formulations.
